# EUROPEAN PATENT SPECIFICATION

(11) **EP 4 546 473 B1**
(45) Date of publication and mention of the grant of the patent: **26.11.2025**
(21) Application number: 23205505.3
(22) Date of filing: 24.10.2023
(51) Int. Cl.: H01M 8/04029, H01M 8/0432

(54) **VEHICLE FUEL CELL SENSOR PLAUSIBILITY CHECK**
PLAUSIBILITÄTSPRÜFUNG EINES BRENNSTOFFZELLENSENSORS EINES FAHRZEUGS
CONTRÔLE DE PLAUSIBILITÉ DE CAPTEUR DE PILE À COMBUSTIBLE DE VÉHICULE

(43) Date of publication of application: 30.04.2025
(73) Proprietor: Volvo Truck Corporation, 405 08 Göteborg (SE)
(72) Inventor: ARYA, Pranav, 412 85 GÖTEBORG (SE); BLANC, Ricard, 431 68 MÖLNDAL (SE)
(74) Representative: Ström & Gulliksson AB

(56) References cited:
- EP-A2- 2 615 517
- US-A1- 2008 145 729
- US-A1- 2023 178 769

## Description

### TECHNICAL FIELD

The disclosure relates generally to vehicle fuel cells. In particular aspects, the disclosure relates to a vehicle fuel cell system that is configured to perform a sensor plausibility check, and to a method of operating a vehicle fuel cell system. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

A vehicle fuel cell typically comprises a plurality of fuel cell sensors for controlling and monitoring the operation of the fuel cell. Typically, the fuel cell comprises a number of fuel cell sensors, some of which are redundant and provided for fuel cell sensor plausibility checks.

Prior art solutions are found in US2023/178769 and US2008/145729.

### SUMMARY

According to a first aspect of the disclosure, there is provided a vehicle fuel cell system assembly that comprises a first fuel cell system comprising a first sensor and a first control unit adapted to control the first fuel cell system based on a value of the first sensor; a second fuel cell system comprising a second sensor and a second control unit adapted to control the second fuel cell system based on a value of the second sensor; and a common supply of coolant, air or fuel to the first and second fuel cell systems. The vehicle fuel cell system assembly is configured to perform a sensor plausibility check of the first sensor and the second sensor, and to use a value of a sensor that has passed the plausibility check instead of a value of a sensor that has not passed the plausibility check. Thereby, operation of the first and second fuel cell systems is allowed in case a sensor does not pass the plausibility check.

The first aspect of the disclosure may seek to solve the problem of increasing the availability or uptime of the vehicle fuel cell system assembly. In some prior art solutions, sensor plausibility checks may be based on a provision of redundant sensors in a fuel cell system. In such solutions, there may be provided a greater number of fuel cell sensors than what is actually required for a particular fuel cell system, such that sensor plausibility checks may be performed within the same fuel cell system. The first aspect of the disclosure may ensure high availability or uptime of the vehicle fuel cell system assembly without the need for additional and redundant fuel cell sensors, and therefore advantages involve a less complex and more cost-effective vehicle fuel cell system. Further, the provision of two, or more, fuel cell systems may be beneficial for the availability or uptime of the vehicle fuel cell system assembly.

Optionally, the vehicle fuel cell system assembly is configured to, based on values from the first sensor and the second sensor, perform a sensor plausibility check of the first sensor and the second sensor.

Optionally, the first and second fuel cell systems comprise or are connected to a common cooling circuit and thus comprise a common supply of coolant.

Optionally, the first and second fuel cell systems comprise or are connect to common media loops, such as a common coolant, air or fuel media loop. The common media loops may be comprised in a vehicle in which the vehicle fuel cell system assembly is arranged.

Optionally, the first and second sensors are temperature sensors and/or pressure sensors. The first and second sensors may be configured to measure a temperature and/or a pressure of a coolant, air or a fuel.

Optionally, the vehicle fuel cell system assembly comprises a vehicle sensor associated with the common supply and a vehicle control unit in communication with the first control unit and the second control unit, wherein the vehicle control unit is configured to, based on values from the first sensor, the second sensor and the vehicle sensor, perform a sensor plausibility check of the first sensor, the second sensor and the vehicle sensor. Advantages include an effective plausibility check of the vehicle sensor, and also of the first sensor and second sensor comprised in the respective fuel cell systems. Further, the sensor plausibility checks may be particularly reliable as the vehicle control unit may be configured to take operating parameters of the vehicle, of the first fuel cell system and also of the second fuel cell system into account when performing the plausibility checks. Such implementation may be comparably cost-effective as there is no need to arrange for a direct communication between the first and second control units. In addition, the vehicle control unit may typically be able to perform appropriate measures in response to a sensor failing a plausibility check.

Optionally, the vehicle sensor is a coolant sensor, an air sensor or a fuel sensor. The vehicle sensor is typically configured to measure a temperature and/or a pressure.

Optionally, the first control unit and the second control unit are in communication with one another, and the first control unit is configured to, based on values from the first sensor and the second control unit, perform a sensor plausibility check of the first sensor, and the second control unit is configured to, based on values from the second sensor and the first control unit, perform a sensor plausibility check of the second sensor. Optionally, the first fuel cell system comprises a third sensor, and the second fuel cell system comprises a fourth sensor, the first control unit and the second control unit are in communication with one another, and the first control unit is configured to, based on values from the first sensor, the third sensor and the second control unit, perform a sensor plausibility check of the first sensor, and the second control unit is configured to, based on values from the second sensor, the fourth sensor and the first control unit, perform a sensor plausibility check of the second sensor. In the latter example, the first and third sensors may be arranged in the same media loop. The second and fourth sensors may be arranged in the same media loop. Advantages include that the respective control units of the fuel cell systems may perform the sensor plausibility checks. For example, no vehicle control unit or similar needs to be involved in the sensor plausibility checks.

Optionally, the vehicle fuel cell system assembly comprises a third fuel cell system comprising a third sensor and a third control unit, wherein the vehicle fuel cell system assembly is configured to, based on values from the first sensor, the second sensor, and the third sensor, perform a sensor plausibility check of the first sensor, the second sensor and the third sensor. Advantages involve that an increased number of fuel cell systems may ensure reliable sensor plausibility checks. Further, the availability of the vehicle fuel cell system assembly may be yet further improved, as operation may be allowed also should several sensors fail a plausibility check.

Optionally, the vehicle fuel cell system assembly may comprise a vehicle control unit in communication with the first control unit of the first fuel cell system and the second control unit of the second fuel cell system. Advantages include that the vehicle control unit may assist in performing the plausibility checks, and that the vehicle control unit may typically be able to perform appropriate measures in response to a sensor failing a plausibility check.

Optionally, the vehicle control unit is configured to, based on values from the first sensor and the second sensor, perform a sensor plausibility check of the first sensor and the second sensor.

Optionally, the vehicle fuel cell system assembly comprises a vehicle sensor that is associated with the common supply.

Optionally, the vehicle fuel cell system assembly is connected to a vehicle sensor that is associated with the common supply.

Optionally, the vehicle control unit is configured to, based on values from the first sensor, the second sensor and the vehicle sensor, perform a sensor plausibility check of the first sensor, the second sensor and the vehicle sensor.

Optionally, the vehicle sensor is a temperature sensor and/or a pressure sensor.

Optionally, the first control unit and the second control unit are in communication with one another, the first fuel cell system comprises a third sensor, the second fuel cell system comprises a fourth sensor, and the first control unit is configured to, based on values from the first sensor, the third sensor and the second control unit, perform a sensor plausibility check of the first sensor, and the second control unit is configured to, based on values from the second sensor, the fourth sensor and the first control unit, perform a sensor plausibility check of the second sensor.

Optionally, the first control unit is configured to perform a sensor plausibility check of the first sensor also based on operating parameters, such as fuel cell power outputs, or state of health information of the first and second fuel cell systems and the second control unit is configured to perform a sensor plausibility check of the second sensor also based on operating parameters, such as fuel cell power outputs, or state of health information of the first and second fuel cell systems.

Optionally, the first and second fuel cell systems are essentially identical. Optionally, the first and second fuel cell systems are different from one another and the vehicle fuel cell system assembly is adapted to take the differences into account when performing the sensor plausibility check.

According to a second aspect of the disclosure, there is provided a vehicle comprising the vehicle fuel cell system assembly.

Optionally, the vehicle is a heavy-duty vehicle such as a truck or a bus. A fuel cell system assembly may be particularly useful in a heavy-duty vehicle to meet the vehicle's energy demand, as pure battery electric heavy-duty vehicles tend to require very large and heavy high voltage batteries. Typically, a heavy-duty vehicle according to the present disclosure comprises a fuel cell system assembly and a high voltage battery.

According to a third aspect of the disclosure, there is provided a method of operating a vehicle fuel cell system assembly, the method comprising first controlling a first fuel cell system by means of a first control unit and based on a value of a first fuel cell sensor; second controlling a second fuel cell system by means of a second control unit and based on a value of a second fuel cell sensor; supplying coolant, air or fuel to the first and second fuel cell systems by means of a common supply; plausibility checking the first sensor and the second sensor; and operating the first and second fuel cell systems by using a value of a sensor that has passed the plausibility check instead of a value of a sensor that has not passed the plausibility check.

Optionally, the plausibility checking of the method is based on values from the first fuel cell sensor and the second fuel cell sensor.

Optionally, the plausibility checking of the method is based on values from the first fuel cell sensor, the second fuel cell sensor and a vehicle sensor.

Optionally, the plausibility checking of the method is based on based on operating parameters, such as fuel cell power outputs, or state of health information of the first and second fuel cell systems.

Optionally, the method of comprises if the first fuel cell sensor does not pass the plausibility check, operating the first and second fuel cell systems by using a value of the vehicle sensor; if the second fuel cell sensor does not pass the plausibility check, operating the first and second fuel cell systems by using a value of the vehicle sensor; and if the vehicle sensor does not pass the plausibility check, operating the first and second fuel cell systems by using a value of the first fuel cell sensor and/or the second fuel cell sensor.

Optionally, the plausibility checking of the method comprises a control unit informing another control unit about which sensor that has not passed the plausibility check.

Optionally, if more than one sensor has not passed the plausibility check, the method comprises reducing a fuel cell power output of the vehicle fuel cell system assembly.

Optionally, the plausibility checking of the method comprises generating a warning message to an operator of the vehicle fuel cell system assembly, in case a sensor has not passed the plausibility check.

Optionally, the method is computer-implemented.

According to a fourth aspect of the disclosure, there is provided a computer program product comprising program code for performing, when executed by a processor device of a controller, the computer-implemented method of operating a vehicle fuel cell system assembly.

According to a fifth aspect of the disclosure, there is provided a non-transitory computer-readable storage medium comprising instructions, which when executed by a processor device of a controller, cause the processing circuitry to perform the computer-implemented method of operating a vehicle fuel cell system assembly.

Advantages and further possible features of the second to fifth aspects correspond to those of the first aspect, and will not be fully repeated herein.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

### BRIEF DESCRIPTION OF THE DRAWINGS

Examples are described in more detail below with reference to the appended drawings.
**FIG. 1** is an exemplary schematic view of a vehicle fuel cell system assembly according to an example.
**FIG. 2** is an exemplary schematic view of a vehicle fuel cell system assembly according to another example.
**FIG. 3** is a block diagram illustrating a method of operating a vehicle fuel cell system assembly according to **FIG. 1** or **FIG. 2****.**
**FIG. 4** is a schematic diagram of an exemplary computer system for implementing examples disclosed herein.

### DETAILED DESCRIPTION

The detailed description set forth below provides information and examples of the disclosed technology with sufficient detail to enable those skilled in the art to practice the disclosure.

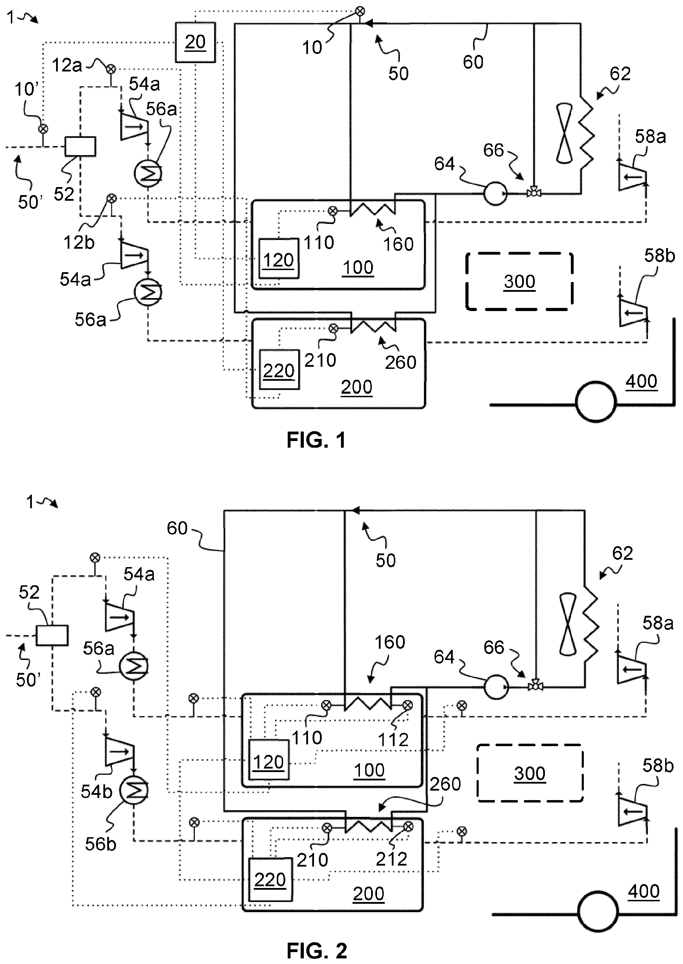

**FIG. 1** shows a vehicle fuel cell system assembly 1 and also indicates a vehicle 400 in which the vehicle fuel cell system assembly 1 may be arranged, e.g. to partially or fully propel the vehicle 400. **FIG. 2** shows an alternative vehicle fuel cell system assembly 1. A vehicle fuel cell system assembly may alternatively be referred to as a vehicle fuel cell system.

The vehicle fuel cell system assembly 1 illustrated in **FIG. 1** and **FIG. 2** comprises a first fuel cell system 100 comprising a first sensor 110 and a first control unit 120 adapted to control the first fuel cell system 100 based on a value of the first sensor 110. The first sensor 110 may be referred to as the first fuel cell sensor 110 and the first control unit 120 may be referred to as the first fuel cell control unit 120.

The vehicle fuel cell system assembly 1 further comprises a second fuel cell system 200 comprising a second sensor 210 and a second control unit 220 adapted to control the second fuel cell system 200 based on a value of the second sensor 210. The second sensor 210 may be referred to as the second fuel cell sensor 210 and second control unit 220 may be referred to as the second fuel cell control unit 220.

Further, in both examples, the vehicle fuel cell system assembly 1 comprises a common supply 50 of coolant, air (50') or fuel (not shown) to the first and second fuel cell systems 100, 200. This may in the context of fuel cells be referred to as the first and second fuel cell systems 100, 200 comprising common media loops (coolant or air or fuel), or that the first and second fuel cell systems 100, 200 are connected to common media loops. In particular the coolant media loop may form a part of the vehicle 400 and therefore not be comprised in the vehicle fuel cell system assembly 1.

Referring to the example of **FIG. 1****,** the first control unit 120 and the second control unit 220 may not be configured to communicate directly with one another. In the example of **FIG. 1****,** the first control unit 120 and the second control unit 220 are not connected directly to one another.

In **FIG. 1** and **FIG. 2****,** a dotted line denotes a communication, e.g. a wired or a wireless communication. Thus, the below described vehicle control unit 20 of the example of **FIG. 1** may be directly connected to the first control unit 120 and directly connected to the second control unit 220. As is shown, in the example of **FIG. 1** the first control unit 120 and the second control unit 220 may communicate with one another via the vehicle control unit 20. In **FIG. 1** and **FIG. 2****,** a solid line denotes a coolant flow line or cooling circuit. A dashed line denotes a cathode supply line and cathode exhaust line, or more generally an air flow line.

The vehicle fuel cell system assembly 1 of the present examples is configured to perform a sensor plausibility check (hereinafter also referred to as plausibility check) of the first sensor 110 and to perform a plausibility check of the second sensor 210. Further, the vehicle fuel cell system assembly 1 is configured to use a value of a sensor 110, 210 that has passed the plausibility check instead of a value of a sensor 110, 210 that has not passed the plausibility check. For example, if the second sensor 210 does not pass the plausibility check, the vehicle fuel cell system assembly 1 may use a value of the first sensor 110 instead of a value of the second sensor 210.

In this way, the vehicle fuel cell system assembly 1 enables or allows operation of the first and second fuel cell systems 100, 200 even in case a sensor 110, 210 of said fuel cell systems 100, 200 does not pass, i.e. fails, the plausibility check.

The vehicle fuel cell system assembly 1 may be configured to, based on values from the first sensor 110 and the second sensor 210, perform a sensor plausibility check of the first sensor 110 and of the second sensor 210.

In the present examples, the first and second fuel cell systems 100, 200 comprise or are connected to a common cooling circuit 60 and thus comprise a common supply 50 of coolant. In other words, the vehicle fuel cell system assembly 1 may provide for cooling of both fuel cell systems 100, 200 using one single cooling circuit 60.

As is shown in **FIG. 1** and **FIG. 2****,** the cooling circuit 60 may comprise one single heat exchanger or radiator 62 that is cooled by a fan. The cooling circuit 60 may further comprise a pump 64 and optionally a three-way valve 66 that together with a bypass coolant line allows the radiator 62 to be partly or fully bypassed for example during warmup of the vehicle fuel cell system assembly 1. As is illustrated, the cooling circuit 60 may further circulate coolant through one heat exchanger 160, 260 in each one of the first and second fuel cell systems 100, 200. Said heat exchangers 160, 260 may preferably be connected in parallel such that the coolant flows that enter the heat exchangers 160, 260 are of essentially the same temperature. Typically, the heat exchangers 160, 260 are in this context incorporated in undepicted fuel cell stacks. Thus, in alternative, the heat exchangers may be referred to as fuel cell stacks.

The first and second sensors 110, 210 may be temperature sensors and/or pressure sensors.

Referring to the example of **FIG. 1****,** the vehicle fuel cell system assembly 1 may comprise a vehicle control unit 20 that is arranged in communication with the first control unit 120 and in communication with the second control unit 220. The present disclosure does not exclude that the vehicle fuel cell system assembly 1 is instead connected to a vehicle control unit 20, i.e. that the vehicle control unit 20 is not comprised in the vehicle fuel cell system assembly 1.

The vehicle fuel cell system assembly 1 may further comprise a vehicle sensor 10. Typically, the vehicle sensor 10 is associated with the common supply 50. In the example of **FIG. 1****,** one common supply 50 may be formed by a cooling circuit 60 and the vehicle sensor 10 may be a temperature or pressure sensor arranged to measure the temperature or pressure of the cooling circuit 60. The vehicle sensor 10 may be arranged to measure the temperature or pressure at the common supply 50. The cooling circuit 60 may be comprised in the vehicle fuel cell system assembly 1. Alternatively, the cooling circuit 60 may be comprised in the vehicle 400 and the vehicle fuel cell system assembly 1 may be connected the cooling circuit 60. The cooling circuit 60 may be arranged to cool other components of the vehicle 400, and not only the vehicle fuel cell system assembly 1. In some examples, the vehicle sensor 10 may be configured to measure both temperature and pressure.

In the context of the present disclosure, the vehicle control unit 20 may be a control unit 20 that is associated with the vehicle 400. The vehicle control unit 20 may perform a number of functions that relate to the operation of the vehicle 400. Thus, the vehicle control unit 20 may not be primarily dedicated to the first or second fuel cell systems 100, 200. In other words, the vehicle control unit 20 may not be comprised in the first or second fuel cell system 100, 200.

In the context of the present disclosure, the vehicle sensor 10 may, as mentioned, be associated with the common supply 50. The vehicle sensor 10 may not be primarily associated with the first or second fuel cell systems 100, 200. In other words, the vehicle sensor 10 may not be comprised in the first or second fuel cell system 100, 200.

The example of **FIG. 1** may be based on the vehicle control unit 20 performing the sensor plausibility check of the first sensor 110, the second sensor 210 and the vehicle sensor 10 based on values from the first sensor 110, the second sensor 210 and the vehicle sensor 10. In some examples, the first sensor 110, the second sensor 210 and the vehicle sensor 10 may all be temperature sensors. Now, since all said sensors 110, 210, 10 may be arranged to measure the temperature of a common cooling circuit 60, see **FIG. 1****,** the sensor plausibility check may be based on the assumption that each sensor 110, 210, 10 should detect essentially the same value. Thus, if one of the sensors detects a value that is different, or substantially different, from the values of the other sensors, the vehicle control unit 20 may draw the conclusion that the sensor that detects a substantially different value malfunctions and hence does not pass the plausibility check. In this example, the first sensor 110 may be referred to as a first coolant sensor 110, the second sensor 210 may be referred to as a second coolant sensor 210, and the vehicle sensor 10 may be referred to as a vehicle coolant sensor 10.

In the example of **FIG. 1****,** the first coolant sensor 110, the second coolant sensor 210 and the vehicle coolant sensor 10 are all arranged operatively immediately downstream the radiator 62 of the cooling circuit, which may facilitate the sensor plausibility check. If the first coolant sensor 110, the second coolant sensor 210 and the vehicle coolant sensor 10 are all arranged with no substantial heat source or heat sink in between them, each coolant sensor 110, 210, 10 should detect essentially the same temperature value.

In more detail, in the example of **FIG. 1** the vehicle coolant sensor 10 is preferably arranged downstream the radiator 62, the first coolant sensor 110 is arranged upstream the heat exchanger 160 of the first fuel cell system 100 and the second coolant sensor 210 is arranged upstream the heat exchanger 260 of the second fuel cell system 200. The radiator 62 may be referred to as the common radiator 62, the heat exchanger 160 of the first fuel cell system 100 may be referred to as the first heat exchanger 160, and the heat exchanger 260 of the second fuel cell system 200 may be referred to as the second heat exchanger 260.

Referring still to **FIG. 1****,** the vehicle control unit 20 may be configured to perform sensor plausibility checks of the first and second coolant sensors 110, 210 also based on operating parameters such as fuel cell power outputs of the first and second fuel cell systems 100, 200. Thus, for example, the first coolant sensor 110 may be arranged downstream the first heat exchanger 160 (see sensor 112 of figure 2) and the vehicle control unit 20 may take the power output of the first fuel cell system 100 into account, meaning that the sensor plausibility check may be based on the assumption that the first coolant sensor 110 is expected to detect a higher temperature value since the coolant is heated when flowing through the first heat exchanger 160 before reaching the first coolant sensor 110 (if arranged downstream the first heat exchanger 160). The first fuel cell control unit 120, knowing e.g. the power output of the first fuel cell system 100, may be configured to calculate an expected temperature value of the first coolant sensor 110.

Similarly, the vehicle control unit 20 may be configured to perform sensor plausibility checks of the first and second coolant sensors 110, 210 also based on state of health information of the first and second fuel cell systems 100, 200. For example, the first fuel cell system 100 may have a worse state of health than the second fuel cell system 200, and the vehicle control unit 20 may in view thereof expect e.g. the first coolant sensor 110 to detect a higher temperature.

In some examples, the vehicle control unit 20 of **FIG. 1** may be configured to perform sensor plausibility checks of the first and second coolant sensors 110, 210 based on values from the coolant first sensor 110, the second coolant sensor 210 and the vehicle coolant sensor 10, based on operating parameters of the first and second fuel cell systems 100, 200, and in addition based on state of health information of the first and second fuel cell systems 100, 200.

As is to be apprehended, referring to the example of **FIG. 1** the plausibility check may be performed in a similar manner should the first coolant sensor 110, the second coolant sensor 210 and the vehicle coolant sensor 10 all be pressure sensors.

Referring to the above description of the example of **FIG. 1****,** in one aspect the present disclosure relates to in a multiple fuel cell system assembly 1, which comprises at least a first and a second fuel cell system 100, 200 and a common supply 50, performing sensor plausibility checks for the same or corresponding sensors 110, 210 of the at least two fuel cell systems 100, 200. It is to be apprehended that the same or similar technology may be applied to sensors associated with air supply (cathode supply), fuel supply (anode supply), and coolant supply.

As is shown in **FIG. 1** and **FIG. 2****,** in the first and second examples the vehicle fuel cell system assembly 1 comprises a common air intake or air supply 50'. A common air filter 52 may be arranged downstream the common air supply 50'. In or downstream the common air filter 52, the common supply air flow may be divided into a separate air flows to the first and second fuel cell systems 100, 200. Thus, there may be a first supply air compressor 54a and a first supply air cooler 56a and separate second supply air compressor 54b and a second supply air cooler 56b. Further, a first turbine 58a may be arranged to harvest energy from a first fuel cell system 100 cathode outlet and a second turbine 58b may be arranged to harvest energy from a second fuel cell system 200 cathode outlet. There may be undepicted coolant lines connecting the first supply air cooler 56a and the second supply air cooler 56b to the cooling circuit 60.

Referring again the example of **FIG. 1****,** the vehicle fuel cell system assembly 1 may comprise a vehicle sensor 10' arranged at the common air supply 50' to measure the temperature and/or the pressure of the air that is to be supplied to the fuel cell cathodes. Thus, said vehicle sensor 10' may be referred to as a vehicle air sensor 10'. The first and second fuel cell systems 100, 200 may comprise undepicted first and second air sensors. Now, the example of **FIG. 1** may be based on the vehicle control unit 20 performing the sensor plausibility check of the first air sensor, the second air sensor and the vehicle air sensor based on values from the first air sensor, the second air sensor and the vehicle air sensor 10'. In this case, since there are typically supply air compressors 54a, 54b and supply air coolers 56a, 56b arranged between the common air supply 50' and the respective first and second fuel cell systems 100, 200, the vehicle control unit 20 typically needs to take operating parameters of the first and second fuel cell systems 100, 200 into account when performing the sensor plausibility checks. More precisely operating parameters of the supply air compressors 54a, 54b and supply air coolers 56a, 56b that are associated with the first and second fuel cell systems 100, 200.

It is to be apprehended that the example of **FIG. 1** is in addition applicable to sensor plausibility checks of undepicted vehicle fuel sensors and first and second fuel sensors. In such a case, the vehicle fuel cell system assembly 1 may comprise a common fuel tank, typically comprising hydrogen, and a common fuel supply to the first and second fuel cell systems 100, 200.

As is schematically illustrated as a dashed rectangle in **FIG. 1****,** the vehicle fuel cell system assembly 1 of the example **FIG. 1** may comprise a third fuel cell system 300. The third fuel cell system 300 may comprise an undepicted third sensor and a third control unit. The vehicle fuel cell system assembly 1 may in such a case be configured to, based on values from the first sensor 110, the second sensor 210 and the third sensor, perform a sensor plausibility check of the first sensor 110, the second sensor 210 and the third sensor. The first, second and third fuel cell systems may comprise a common supply of coolant, air or fuel. Without repeating the above description of the example of **FIG. 1****,** the vehicle control unit 20 may perform the sensor plausibility check of the first sensor 110, the second sensor 210, the third sensor and the vehicle sensor 10 based on values from the first sensor 110, the second sensor 210, the third sensor and the vehicle sensor 10.

Referring to the alternative vehicle fuel cell system assembly 1 of **FIG. 2****,** the vehicle fuel cell system assembly 1 may be configured to perform the sensor plausibility checks by means of the first fuel cell control unit 120 and the second fuel cell control unit 220. In the example of **FIG. 2****,** the sensor plausibility checks are not performed by a vehicle control unit. **FIG. 2** illustrates a first fuel cell control unit 120 a second fuel cell control unit 220, but no vehicle control unit. It is to be apprehended that the vehicle fuel cell system assembly 1 of **FIG. 2** may typically be arranged in a vehicle 400 that comprises a vehicle control unit that is in communication with the first and second fuel cell control units 120, 220, but that vehicle control unit is not involved in the sensor plausibility checks.

In the example of **FIG. 2****,** the first control unit 120 and the second control unit 220 are configured to communicate directly with one another. In this case, the first control unit 120 and the second control unit 220 may be directly connected to one another (as is illustrated in **FIG. 2****).**

In the example of **FIG. 2****,** the first control unit 120 and the second control unit 220 are in communication with one another, and the first control unit 120 is configured to, based on values from the first sensor 110 and the second control unit 220, perform a sensor plausibility check of the first sensor 110. The second control unit 220 is configured to, based on values from the second sensor 210 and the first control unit 120, perform a sensor plausibility check of the second sensor 210.

In the example of **FIG. 2****,** the first (fuel cell) control unit 120 may receive a value from the first (fuel cell) sensor 110 and also from the second (fuel cell) sensor 210 via the second (fuel cell) control unit 220. As is illustrated, the first control unit 120 is connected to the second control unit 220. Further, the first sensor 110 is connected to the first control unit 120 and the second sensor 210 is connected to the second control unit 220. Referring to the description of the examples of **FIG. 1****,** since the first and second fuel cell systems 100, 200 comprise or are connected to a common cooling circuit 60 and thus comprise a common supply 50 of coolant (or air or fuel), the sensor plausibility check may be based on the assumption that the first and second sensors 110, 210 should detect essentially the same value.

As is shown in **FIG. 2****,** the first fuel cell system 100 may comprise a third sensor 112. In the present example, the first sensor 110 of the first fuel cell system 100 is arranged upstream the heat exchanger 160 and the third sensor 112 is arranged downstream the heat exchanger. Thus, the first and third sensors 110, 112 are arranged in the same media loop (here: coolant media loop). Similarly, the second fuel cell system 200 may comprise a fourth sensor 212. The second sensor 210 of the second fuel cell system 200 may be arranged upstream the heat exchanger 260 and the fourth sensor 212 may be arranged downstream the heat exchanger 260. Thus, the second and fourth sensors 210, 212 are arranged in the same media loop (here: coolant media loop). By means of the third and/or fourth sensors 112, 212, the sensor plausibility checks may be improved. The first fuel cell control unit 120 may receive a value from the first fuel cell sensor 110, the third fuel cell sensor 112, and also from the second and fourth fuel cell sensors 210, 212 via the second fuel cell control unit 220. The second fuel cell control unit 220 may receive a value from the second fuel cell sensor 210, the fourth fuel cell sensor 212, and also from the first and third fuel cell sensors 110, 112 via the first fuel cell control unit 120. The first and third sensors 110, 112 are connected to the first control unit 120 and the second and fourth sensors 210, 212 are connected to the second control unit 220.

Further, at least one of the control units 120, 220 may, based e.g. on the power output of the first or second fuel cell system 100, 200, be configured to calculate an expected value of its assigned sensor(s), in the present example the third and fourth sensors 112, 212. For example, the first control unit 120 may be configured to, based on a value from the first sensor 110, the third sensor 112, a calculated expected value of the third sensor 112, and values from the second control unit 220 (e.g. a value of the second sensor 210), perform a sensor plausibility check of the third sensor 112. The second control unit 220 may be configured to operate in the corresponding manner.

As is illustrated **(****FIG. 1** and **FIG. 2****),** the first and second fuel cell systems 100, 200 may be essentially identical. It is to be apprehended that if the first and second fuel cell systems 100, 200 are not essentially identical but of different designs, or of different power ratings, then the vehicle fuel cell system assembly 1 may be adapted to take such differences into account when performing the sensor plausibility check.

As is schematically illustrated as a dashed rectangle in **FIG. 2****,** the vehicle fuel cell system assembly 1 of the example **FIG. 2** may comprise a third fuel cell system 300. The third fuel cell system 300 may comprise an undepicted third sensor and a third control unit. The first control unit 120 may receive a value from the first sensor 110, a value from the second sensor 210 via the second control unit 220, and a value from the third sensor via the third control unit. The sensor plausibility check may be performed by the respective control units in the same manner as described with reference to the above example of in **FIG. 2****.** The first, second and third fuel cell system may be, but need not be, essentially identical.

In the examples of **FIG. 2****,** the (fuel cell) control units may communicate with one another such that all control units know which, if any, of the sensors 110 that do not pass the plausibility check. The control unit of the fuel cell system that comprises the sensor that has not passed the plausibility check may then instead use a sensor value from a fuel cell system that comprises a sensor that has passed the plausibility check. If a first fuel cell system comprises the sensor that has not passed the plausibility check, and the first control unit is in communication with a plurality of other control units that comprise sensors that have passed the plausibility check, a mean value of those sensors may be used by the first control unit instead of a value of the first sensor.

**FIG. 2** shows a number of sensors that are not denoted with reference numerals, such as the sensors arranged operatively upstream the first and second supply air compressors 54a, 54b and the sensors at the outlet of the first and second heat exchangers 160, 260. These sensors are, as illustrated, arranged in communication with either the first fuel cell control unit 120 or the second fuel cell control unit 220. It is to be appended that the vehicle fuel cell system assembly 1 of **FIG. 2** may be configured to perform a sensor plausibility check of each one of these sensors.

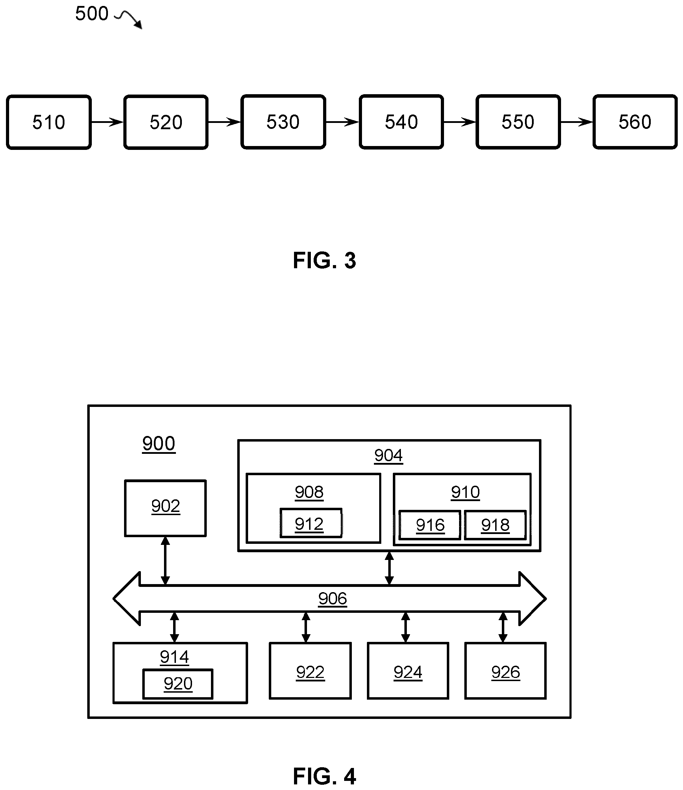

**FIG. 3** illustrates a method 500 of operating a vehicle fuel cell system assembly. The method 500 comprises controlling 510 a first fuel cell system 100 by means of a first control unit 120 and based on a value of a first fuel cell sensor 110. Said controlling may be referred to as a first controlling 510 as is relates to the first fuel cell system 100.

The method 500 further comprises controlling 520 a second fuel cell system 200 by means of a second control unit 220 and based on a value of a second fuel cell sensor 210. Said controlling may be referred to as a second controlling 520 as is relates to the second fuel cell system 200. The first controlling 510 and the second controlling 520 are typically performed simultaneously.

The method 500 further comprises supplying 530 coolant, air or fuel to the first and second fuel cell systems 100, 200 by means of a common supply 50.

The method 500 further comprises plausibility checking 540 the first sensor 110 and the second sensor 210.

The method 500 further comprises operating 550 the first and second fuel cell systems 100, 200 by using a value of a sensor 110, 210 that has passed the plausibility check instead of a value of a sensor 110, 210 that has not passed the plausibility check.

The method 500 may for example be performed on a vehicle fuel cell system assembly of the type described with reference to **FIG. 1****.** Therefore, the components of the vehicle fuel cell system assembly are not described again. Further, all details of the examples of the method 500 will not be described again.

As has been described, the plausibility checking 540 is typically based on values from the first fuel cell sensor 110 and the second fuel cell sensor 210. In more detail, as has been described with reference to the examples of **FIG. 1****,** the plausibility checking 540 may be based on values from the first fuel cell sensor 110, the second fuel cell sensor 210 and a vehicle sensor 10 that is associated with the common supply 50. In addition, the plausibility checking 540 may be based on based on operating parameters, such as fuel cell power outputs, or state of health information of the first and second fuel cell systems 100, 200.

If the first fuel cell sensor 110 does not pass the plausibility check, the method 500 may provide for operating 550 the first and second fuel cell systems 100, 200 by using a value of the vehicle sensor 10.

If the second fuel cell sensor 210 does not pass the plausibility check, the method 500 may provide for operating 550 the first and second fuel cell systems 100, 200 by using a value of the vehicle sensor 10.

If the vehicle sensor 10 does not pass the plausibility check, the method 500 may provide for operating 550 the first and second fuel cell systems 100, 200 by using a value of the first fuel cell sensor 110 and/or the second fuel cell sensor 210.

The plausibility checking 540 may comprise a control unit 120, 220, 20 informing another control unit 120, 220, 20 about which sensor 110, 210, 10 that has failed the plausibility check. The plausibility checking 540 may in addition comprise generating a warning message to an operator of the vehicle fuel cell system assembly. Typically, the operator may be a driver of a vehicle in which the vehicle fuel cell system assembly is arranged. The vehicle fuel cell system assembly may continue its operation, but the operator may arrange for expeditious or immediate service. For example, a driver may schedule a vehicle service or may immediately drive the vehicle to a workshop or a service center.

As has been described with reference to the examples of **FIG. 2****,** the plausibility checking 540 may be performed by the first and the second vehicle control units 120, 220 based on values from the first fuel cell sensor 110 and the second fuel cell sensor 210 and optionally on values from third and fourth sensors 112, 212. In addition, the plausibility checking 540 may be based on based on operating parameters, such as fuel cell power outputs, or state of health information of the first and second fuel cell systems 100, 200.

In such a case, if the first fuel cell sensor 110 does not pass the plausibility check, the method 500 may provide for operating 550 the first fuel cell system 100 by using a value of the second fuel cell sensor 210 sensor. If the second fuel cell sensor 210 does not pass the plausibility check, the method 500 may provide for operating 550 the second fuel cell system 200 by using a value of the first fuel cell sensor 110.

In accordance with the method 500, if a sensor 110, 210, 10 has failed the plausibility check, the method 500 may provide for reducing 560 a fuel cell power output of the vehicle fuel cell system assembly 1. Typically, however, the method 500 may entail reducing a fuel cell power output of the vehicle fuel cell system assembly 1 only if more than one sensor has failed the plausibility check.

The first and a second fuel cell systems 100, 200 typically each comprise undepicted fuel cell stacks with bipolar plates, electrical connections, inputs and outputs for cathode gas (typically air) and anode gas (such as hydrogen). As this disclosure primary relates to sensor plausibility checking and not to the fuel cell systems per se, the functions and features of the fuel cell systems are not described in detail.

The above-described methods are typically computer-implemented. **FIG. 4** is a schematic diagram of a computer system 900 for implementing examples disclosed herein. The computer system 900 is adapted to execute instructions from a computer-readable medium to perform these and/or any of the functions or processing described herein. The computer system 900 may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system 900 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 900 may comprise at least one computing device or electronic device capable of including firmware, hardware, and/or executing software instructions to implement the functionality described herein. The computer system 900 may include processing circuitry 902 (e.g., processing circuitry including one or more processor devices or control units), a memory 904, and a system bus 906. The computer system 900 may include at least one computing device having the processing circuitry 902. The system bus 906 provides an interface for system components including, but not limited to, the memory 904 and the processing circuitry 902. The processing circuitry 902 may include any number of hardware components for conducting data or signal processing or for executing computer code stored in memory 904. The processing circuitry 902 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 902 may further include computer executable code that controls operation of the programmable device.

The system bus 906 may be any of several types of bus structures that may further interconnect to a memory bus (with or without a memory controller), a peripheral bus, and/or a local bus using any of a variety of bus architectures. The memory 904 may be one or more devices for storing data and/or computer code for completing or facilitating methods described herein. The memory 904 may include database components, object code components, script components, or other types of information structure for supporting the various activities herein. Any distributed or local memory device may be utilized with the systems and methods of this description. The memory 904 may be communicably connected to the processing circuitry 902 (e.g., via a circuit or any other wired, wireless, or network connection) and may include computer code for executing one or more processes described herein. The memory 904 may include non-volatile memory 908 (e.g., read-only memory (ROM), erasable programmable read-only memory (EPROM), electrically erasable programmable read-only memory (EEPROM), etc.), and volatile memory 910 (e.g., random-access memory (RAM)), or any other medium which can be used to carry or store desired program code in the form of machine-executable instructions or data structures and which can be accessed by a computer or other machine with processing circuitry 902. A basic input/output system (BIOS) 912 may be stored in the non-volatile memory 908 and can include the basic routines that help to transfer information between elements within the computer system 900.

The computer system 900 may further include or be coupled to a non-transitory computer-readable storage medium such as a storage device 914, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 914 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device 914 and/or in the volatile memory 910, which may include an operating system 916 and/or one or more program modules 918. All or a portion of the examples disclosed herein may be implemented as a computer program 920 stored on a transitory or non-transitory computer-usable or computer-readable storage medium (e.g., single medium or multiple media), such as the storage device 914, which includes complex programming instructions (e.g., complex computer-readable program code) to cause the processing circuitry 902 to carry out actions described herein. Thus, the computer-readable program code of the computer program 920 can comprise software instructions for implementing the functionality of the examples described herein when executed by the processing circuitry 902. In some examples, the storage device 914 may be a computer program product (e.g., readable storage medium) storing the computer program 920 thereon, where at least a portion of a computer program 920 may be loadable (e.g., into a processor) for implementing the functionality of the examples described herein when executed by the processing circuitry 902. The processing circuitry 902 may serve as a controller or control system for the computer system 900 that is to implement the functionality described herein.

The computer system 900 may include an input device interface 922 configured to receive input and selections to be communicated to the computer system 900 when executing instructions, such as from a keyboard, mouse, touch-sensitive surface, etc. Such input devices may be connected to the processing circuitry 902 through the input device interface 922 coupled to the system bus 906 but can be connected through other interfaces, such as a parallel port, an Institute of Electrical and Electronic Engineers (IEEE) 1394 serial port, a Universal Serial Bus (USB) port, an IR interface, and the like. The computer system 900 may include an output device interface 924 configured to forward output, such as to a display, a video display unit (e.g., a liquid crystal display (LCD) or a cathode ray tube (CRT)). The computer system 900 may include a communications interface 926 suitable for communicating with a network as appropriate or desired.

A sensor plausibility check may be defined as a method in which a sensor value is checked to see whether it is plausible or not. In other words, whether the sensor value is acceptable, plausible and comprehensible or not.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Also disclosed are examples according to the following clauses:
1. A vehicle fuel cell system assembly (1) comprising
   - a first fuel cell system (100) comprising a first sensor (110) and a first control unit (120) adapted to control the first fuel cell system (100) based on a value of the first sensor (110),
   - a second fuel cell system (200) comprising a second sensor (210) and a second control unit (220) adapted to control the second fuel cell system (200) based on a value of the second sensor (210), and
   - a common supply (50) of coolant, air or fuel to the first and second fuel cell systems (100, 200),
   wherein the vehicle fuel cell system assembly (1) is configured to perform a sensor plausibility check of the first sensor (110) and the second sensor (210), and to use a value of a sensor (110, 210) that has passed the plausibility check instead of a value of a sensor (110, 210) that has not passed the plausibility check, such that operation of the first and second fuel cell systems (100, 200) is allowed in case a sensor (110, 210) does not pass the plausibility check.
2. The vehicle fuel cell system assembly (1) of clause 1, configured to, based on values from the first sensor (110) and the second sensor (210), perform a sensor plausibility check of the first sensor (110) and the second sensor (210).
3. The vehicle fuel cell system assembly (1) of clause 1 or 2, wherein the first and second fuel cell systems (100, 200) comprise or are connected to a common cooling circuit (60) and thus a common supply (50) of coolant.
4. The vehicle fuel cell system assembly (1) of clause 3, wherein the first and second sensors (110, 210) are temperature sensors and/or pressure sensors.
5. The vehicle fuel cell system assembly (1) of any preceding clause, either comprising a vehicle sensor (10) associated with the common supply (50) and a vehicle control unit (20) in communication with the first control unit (120), the second control unit (220) and the vehicle sensor (10),
   wherein the vehicle control unit (20) is configured to, based on values from the first sensor (110), the second sensor (210) and the vehicle sensor (10), perform a sensor plausibility check of the first sensor (110), the second sensor (210) and the vehicle sensor (10),
      or
   the first fuel cell system (100) optionally comprising a third sensor (112), and the second fuel cell system (200) optionally comprising a fourth sensor (212), wherein the first control unit (120) and the second control unit (220) are in communication with one another, and the first control unit (120) is configured to, based on values from the first sensor (110), optionally the third sensor (112) and the second control unit (220), perform a sensor plausibility check of the first sensor (110), and the second control unit (220) is configured to, based on values from the second sensor (210), optionally the fourth sensor (212) and the first control unit (120), perform a sensor plausibility check of the second sensor (210).
6. The vehicle fuel cell system assembly (1) of any preceding clause, comprising a third fuel cell system (300) comprising a third sensor (310) and a third control unit (320), wherein the vehicle fuel cell system assembly (1) is configured to, based on values from the first sensor (110), the second sensor (210), and the third sensor (310), perform a sensor plausibility check of the first sensor (110), the second sensor (210) and the third sensor (310).
7. The vehicle fuel cell system assembly (1) of any preceding clause, comprising a vehicle control unit (20) in communication with the first control unit (120) of the first fuel cell system (100) and the second control unit (220) of the second fuel cell system (200).
8. The vehicle fuel cell system assembly (1) of clause 7, wherein the vehicle control unit (20) is configured to, based on values from the first sensor (110) and the second sensor (210), perform a sensor plausibility check of the first sensor (110) and the second sensor (210).
9. The vehicle fuel cell system assembly (1) of any preceding clause, comprising or connected to a vehicle sensor (10) that is associated with the common supply (50).
10. The vehicle fuel cell system assembly (1) of clause 9, wherein the vehicle sensor (10) is coolant sensor, an air sensor or a fuel sensor, and wherein the vehicle sensor (10) is configured to measure a temperature and/or a pressure.
11. The vehicle fuel cell system assembly (1) of clause 7 and clause 9 or 10, wherein the vehicle control unit (20) is configured to, based on values from the first sensor (110), the second sensor (210) and the vehicle sensor (10), perform a sensor plausibility check of the first sensor (110), the second sensor (210) and the vehicle sensor (10).
12. The vehicle fuel cell system assembly (1) of clause 11, wherein the vehicle sensor (10) is a temperature sensor or a pressure sensor.
13. The vehicle fuel cell system assembly (1) of any preceding clause, wherein the first control unit (120) and the second control unit (220) are in communication with one another, the first fuel cell system (100) comprises a third sensor (112), the second fuel cell system (200) comprises a fourth sensor (212), and
   the first control unit (120) is configured to, based on values from the first sensor (110), the third sensor (112) and the second control unit (220), perform a sensor plausibility check of the first sensor (110), and
   the second control unit (220) is configured to, based on values from the second sensor (210) , the fourth sensor (212) and the first control unit (120), perform a sensor plausibility check of the second sensor (210).
14. The vehicle fuel cell system assembly (1) of clause 13, wherein
   the first control unit (120) is configured to perform a sensor plausibility check of the first sensor (110) also based on operating parameters, such as fuel cell power outputs, or state of health information of the first and second fuel cell systems (100, 200) and the second control unit (220) is configured to perform a sensor plausibility check of the second sensor (210) also based on operating parameters or state of health information, such as fuel cell power outputs, of the first and second fuel cell systems (100, 200).
15. The vehicle fuel cell system assembly (1) of any preceding clause, wherein the first and second fuel cell systems (100, 200) are essentially identical, or wherein the first and second fuel cell systems (100, 200) are different from one another and the vehicle fuel cell system assembly (1) is adapted to take the differences into account when performing the sensor plausibility check.
16. A vehicle (400) comprising the vehicle fuel cell system assembly (1) according to any preceding clauses.
17. The vehicle (400) of clause 16, wherein the vehicle (400) is a heavy-duty vehicle such as a truck or a bus.
18. A method (500) of operating a vehicle fuel cell system assembly (1), the method (500) comprising
   - first controlling (510) a first fuel cell system (100) by means of a first control unit (120) and based on a value of a first fuel cell sensor (110),
   - second controlling (520) a second fuel cell system (200) by means of a second control unit (220) and based on a value of a second fuel cell sensor (210),
   - supplying (530) coolant, air or fuel to the first and second fuel cell systems (100, 200) by means of a common supply (50),
   - plausibility checking (540) the first sensor (110) and the second sensor (210), and
   - operating (550) the first and second fuel cell systems (100, 200) by using a value of a sensor (110, 210) that has passed the plausibility check instead of a value of a sensor (110, 210) that has not passed the plausibility check.
19. The method (500) of clause 18, wherein the plausibility checking (540) is based on values from the first fuel cell sensor (110) and the second fuel cell sensor (210).
20. The method (500) of clause 18, wherein the plausibility checking (540) is based on values from the first fuel cell sensor (110), the second fuel cell sensor (210) and a vehicle sensor (10) that is associated with the common supply (50).
21. The method (500) of clause 19 or 20, wherein the plausibility checking (540) is based on based on operating parameters, such as fuel cell power outputs, or state of health information of the first and second fuel cell systems (100, 200).
22. The method (500) of clause 20, comprising
   if the first fuel cell sensor (110) does not pass the plausibility check, operating (550) the first and second fuel cell systems (100, 200) by using a value of the vehicle sensor (10),
   if the second fuel cell sensor (210) does not pass the plausibility check, operating (550) the first and second fuel cell systems (100, 200) by using a value of the vehicle sensor (10), and
   if the vehicle sensor (10) does not pass the plausibility check, operating (550) the first and second fuel cell systems (100, 200) by using a value of the first fuel cell sensor (110) and/or the second fuel cell sensor (210).
23. The method (500) according to any of clauses 18 to 22, wherein the plausibility checking (540) comprises a control unit (120, 220, 20) informing another control unit (120, 220, 20) about which sensor (110, 210, 10) that has not passed the plausibility check.
24. The method (500) of clause 23, wherein the plausibility checking (540) comprises generating a warning message to an operator of the vehicle fuel cell system assembly.
25. The method (500) of clause 23 or 24, comprising, if more than one sensor (110, 210, 10) has not passed the plausibility check, reducing (560) a fuel cell power output of the vehicle fuel cell system assembly (1).

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A vehicle fuel cell system assembly (1) comprising
- a first fuel cell system (100) comprising a first sensor (110) and a first control unit (120) adapted to control the first fuel cell system (100) based on a value of the first sensor (110),
- a second fuel cell system (200) comprising a second sensor (210) and a second control unit (220) adapted to control the second fuel cell system (200) based on a value of the second sensor (210), and
- a common supply (50) of coolant, air or fuel to the first and second fuel cell systems (100, 200),
wherein the vehicle fuel cell system assembly (1) is configured to perform a sensor plausibility check of the first sensor (110) and the second sensor (210), **characterized in that the** vehicle fuel cell system assembly (1) is further configured to use a value of a sensor (110, 210) that has passed the plausibility check instead of a value of a sensor (110, 210) that has not passed the plausibility check, such that operation of the first and second fuel cell systems (100, 200) is allowed in case a sensor (110, 210) does not pass the plausibility check.

2. The vehicle fuel cell system assembly (1) of claim 1, wherein the first and second fuel cell systems (100, 200) comprise or are connected to a common cooling circuit (60) and thus comprise a common supply (50) of coolant, and wherein the first and second sensors (110, 210) are temperature sensors and/or pressure sensors.

3. The vehicle fuel cell system assembly (1) of claim 1 or 2, either comprising
- a vehicle sensor (10) associated with the common supply (50), and
- a vehicle control unit (20) in communication with the first control unit (120), the second control unit (220) and the vehicle sensor (10),
wherein the vehicle control unit (20) is configured to, based on values from the first sensor (110), the second sensor (210) and the vehicle sensor (10), perform a sensor plausibility check of the first sensor (110), the second sensor (210) and the vehicle sensor (10),
or
- the first fuel cell system (100) optionally comprising a third sensor (112), and
- the second fuel cell system (200) optionally comprising a fourth sensor (212), wherein the first control unit (120) and the second control unit (220) are in communication with one another, and the first control unit (120) is configured to, based on values from the first sensor (110), optionally the third sensor (112) and the second control unit (220), perform a sensor plausibility check of the first sensor (110), and the second control unit (220) is configured to, based on values from the second sensor (210), optionally the fourth sensor (212) and the first control unit (120), perform a sensor plausibility check of the second sensor (210),
or
comprising
- a third fuel cell system (300) comprising a third sensor (310) and a third control unit (320),
wherein the vehicle fuel cell system assembly (1) is configured to, based on values from the first sensor (110), the second sensor (210), and the third sensor (310), perform a sensor plausibility check of the first sensor (110), the second sensor (210) and the third sensor (310).

4. The vehicle fuel cell system assembly (1) of any preceding claim, comprising a vehicle control unit (20) in communication with the first control unit (120) of the first fuel cell system (100) and with the second control unit (220) of the second fuel cell system (200), wherein the vehicle control unit (20) is configured to, based on values from the first sensor (110) and the second sensor (210), perform a sensor plausibility check of the first sensor (110) and the second sensor (210).

5. The vehicle fuel cell system assembly (1) of any preceding claim, comprising or connected to a vehicle sensor (10) associated with the common supply (50).

6. The vehicle fuel cell system assembly (1) of claims 4 and 5, wherein the vehicle control unit (20) is configured to, based on values from the first sensor (110), the second sensor (210) and the vehicle sensor (10), perform a sensor plausibility check of the first sensor (110), the second sensor (210) and the vehicle sensor (10).

7. The vehicle fuel cell system assembly (1) of any preceding claim, wherein the first control unit (120) and the second control unit (220) are in communication with one another, the first control unit (120) comprises a third sensor (112), the second control unit (220) comprises a fourth sensor (212), and
the first control unit (120) is configured to, based on values from the first sensor (110), the third sensor (112) and the second control unit (220), perform a sensor plausibility check of the first sensor (110), and
the second control unit (220) is configured to, based on values from the second sensor (210), the fourth sensor (212) and the first control unit (120), perform a sensor plausibility check of the second sensor (210).

8. The vehicle fuel cell system assembly (1) of any preceding claim, wherein the first and second fuel cell systems (100, 200) are essentially identical, or wherein the first and second fuel cell systems (100, 200) are different from one another and the vehicle fuel cell system assembly (1) is adapted to take the differences into account when performing the sensor plausibility check.

9. A vehicle (400) comprising the vehicle fuel cell system assembly (1) according to any preceding claims, wherein the vehicle (400) optionally is a heavy-duty vehicle such as a truck or a bus.

10. A method (500) of operating a vehicle fuel cell system assembly (1), the method (500) comprising:
- first controlling (510) a first fuel cell system (100) by means of a first control unit (120) and based on a value of a first fuel cell sensor (110),
- second controlling (520) a second fuel cell system (200) by means of a second control unit (220) and based on a value of a second fuel cell sensor (210),
- supplying (530) coolant, air or fuel to the first and second fuel cell systems (100, 200) by means of a common supply (50),
- plausibility checking (540) the first sensor (110) and the second sensor (210),
wherein the method is **characterized in that** it further comprises:
- operating (550) the first and second fuel cell systems (100, 200) by using a value of a sensor (110, 210) that has passed the plausibility check instead of a value of a sensor (110, 210) that has not passed the plausibility check.

11. The method (500) of claim 10, wherein the plausibility checking (540) is based on values from the first fuel cell sensor (110), the second fuel cell sensor (210) and a vehicle sensor (10).

12. The method (500) of claim 11, comprising
if the first fuel cell sensor (110) does not pass the plausibility check, operating (550) the first and second fuel cell systems (100, 200) by using a value of the vehicle sensor (10),
if the second fuel cell sensor (210) does not pass the plausibility check, operating (550) the first and second fuel cell systems (100, 200) by using a value of the vehicle sensor (10), and
if the vehicle sensor (10) does not pass the plausibility check, operating (550) the first and second fuel cell systems (100, 200) by using a value of the first fuel cell sensor (110) and/or the second fuel cell sensor (210).

13. The method (500) of claim 10, 11 or 12, wherein the method is computer-implemented.

14. A computer program product comprising program code for performing, when executed by a processor device of a controller (60), the computer-implemented short circuit diagnostic method (100) of claim 13.

15. A non-transitory computer-readable storage medium comprising instructions, which when executed by a processor device of a controller (60), cause the processing circuitry to perform the computer-implemented short circuit diagnostic method (100) of claim 13.

## Patentansprüche

1. Anordnung (1) eines Fahrzeug-Brennstoffzellensystems, umfassend
- ein erstes Brennstoffzellensystem (100), umfassend einen ersten Sensor (110) und eine erste Steuereinheit (120), die dafür ausgelegt ist, das erste Brennstoffzellensystem (100) auf der Grundlage eines Wertes des ersten Sensors (110) zu steuern,
- ein zweites Brennstoffzellensystem (200), umfassend einen zweiten Sensor (210) und eine zweite Steuereinheit (220), die dazu ausgelegt ist, das zweite Brennstoffzellensystem (200) auf der Grundlage eines Wertes des zweiten Sensors (210) zu steuern, und
- eine gemeinsame Versorgung (50) mit Kühlmittel, Luft oder Brennstoff des ersten und des zweiten Brennstoffzellensystems (100, 200),
wobei die Anordnung (1) des Fahrzeug-Brennstoffzellensystems so konfiguriert ist, dass sie eine Sensor-Plausibilitätsprüfung des ersten Sensors (110) und des zweiten Sensors (210) durchführt, **dadurch gekennzeichnet, dass die** Anordnung (1) des Fahrzeug-Brennstoffzellensystems ferner so konfiguriert ist, dass sie einen Wert eines Sensors (110, 210), der die Plausibilitätsprüfung bestanden hat, anstelle eines Wertes eines Sensors (110, 210), der die Plausibilitätsprüfung nicht bestanden hat, verwendet, sodass der Betrieb des ersten und des zweiten Brennstoffzellensystems (100, 200) zugelassen wird, falls ein Sensor (110, 210) die Plausibilitätsprüfung nicht besteht.

2. Anordnung (1) eines Fahrzeug-Brennstoffzellensystems nach Anspruch 1, wobei das erste und das zweite Brennstoffzellensystem (100, 200) einen gemeinsamen Kühlkreislauf (60) aufweisen oder an diesen angeschlossen sind und somit eine gemeinsame Kühlmittelversorgung (50) aufweisen, und wobei der erste und der zweite Sensor (110, 210) Temperatursensoren und/oder Drucksensoren sind.

3. Anordnung (1) eines Fahrzeug-Brennstoffzellensystems nach Anspruch 1 oder 2, umfassend:
- einen Fahrzeugsensor (10), der mit der gemeinsamen Versorgung (50) verbunden ist, und
- eine Fahrzeugsteuereinheit (20), die mit der ersten Steuereinheit (120), der
zweiten Steuereinheit (220) und dem Fahrzeugsensor (10) kommuniziert, wobei die Fahrzeugsteuereinheit (20) so konfiguriert ist, dass sie auf der Grundlage von Werten des ersten Sensors (110), des zweiten Sensors (210) und des Fahrzeugsensors (10) eine Sensorplausibilitätsprüfung des ersten Sensors (110), des zweiten Sensors (210) und des Fahrzeugsensors (10) durchführt,
oder
- das erste Brennstoffzellensystem (100), optional umfassend einen dritten Sensor (112), und
- das zweite Brennstoffzellensystem (200), optional umfassend einen vierten Sensor (212),
wobei die erste Steuereinheit (120) und die zweite Steuereinheit (220) miteinander kommunizieren und die erste Steuereinheit (120) so konfiguriert ist, dass sie, auf der Grundlage von Werten von dem ersten Sensor (110), optional dem dritten Sensor (112) und der zweiten Steuereinheit (220) eine Sensorplausibilitätsprüfung des ersten Sensors (110) durchführt, und die zweite Steuereinheit (220) so konfiguriert ist, dass sie auf der Grundlage von Werten des zweiten Sensors (210), optional des vierten Sensors (212) und der ersten Steuereinheit (120) eine Sensorplausibilitätsprüfung des zweiten Sensors (210) durchführt,
oder
umfassend
- ein drittes Brennstoffzellensystem (300), umfassend einen dritten Sensor (310) und eine dritten Steuereinheit (320),
wobei die Anordnung (1) des Fahrzeug-Brennstoffzellensystems so konfiguriert ist, dass sie auf der Grundlage von Werten des ersten Sensors (110), des zweiten Sensors (210) und des dritten Sensors (310) eine Sensorplausibilitätsprüfung des ersten Sensors (110), des zweiten Sensors (210) und des dritten Sensors (310) durchführt.

4. Anordnung (1) eines Fahrzeug-Brennstoffzellensystems nach einem der vorhergehenden Ansprüche, umfassend eine Fahrzeugsteuereinheit (20), die mit der ersten Steuereinheit (120) des ersten Brennstoffzellensystems (100) und mit der zweiten Steuereinheit (220) des zweiten Brennstoffzellensystems (200) kommuniziert, wobei die Fahrzeugsteuereinheit (20) so konfiguriert ist, dass sie auf der Grundlage von Werten von dem ersten Sensor (110) und dem zweiten Sensor (210) eine Sensorplausibilitätsprüfung des ersten Sensors (110) und des zweiten Sensors (210) durchführt.

5. Anordnung (1) eines Fahrzeug-Brennstoffzellensystems nach einem der vorhergehenden Ansprüche, die einen Fahrzeugsensor (10), der mit der gemeinsamen Versorgung (50) verbunden ist, umfasst oder damit verbunden ist.

6. Anordnung (1) eines Fahrzeug-Brennstoffzellensystems nach den Ansprüchen 4 und 5, wobei die Fahrzeugsteuereinheit (20) so konfiguriert ist, dass sie auf der Grundlage von Werten des ersten Sensors (110), des zweiten Sensors (210) und des Fahrzeugsensors (10) eine Sensorplausibilitätsprüfung des ersten Sensors (110), des zweiten Sensors (210) und des Fahrzeugsensors (10) durchführt.

7. Anordnung (1) eines Fahrzeug-Brennstoffzellensystems nach einem der vorhergehenden Ansprüche, wobei die erste Steuereinheit (120) und die zweite Steuereinheit (220) miteinander kommunizieren, die erste Steuereinheit (120) einen dritten Sensor (112) umfasst, die zweite Steuereinheit (220) einen vierten Sensor (212) umfasst, und
die erste Steuereinheit (120) so konfiguriert ist, dass sie auf der Grundlage von Werten von dem ersten Sensor (110), dem dritten Sensor (112) und der zweiten Steuereinheit (220) eine Sensorplausibilitätsprüfung des ersten Sensors (110) durchführt, und
die zweite Steuereinheit (220) so konfiguriert ist, dass sie auf der Grundlage von Werten von dem zweiten Sensor (210), dem vierten Sensor (212) und der ersten Steuereinheit (120) eine Sensorplausibilitätsprüfung des zweiten Sensors (210) durchführt.

8. Anordnung (1) eines Fahrzeug-Brennstoffzellensystems nach einem der vorhergehenden Ansprüche, wobei das erste und das zweite Brennstoffzellensystem (100, 200) im Wesentlichen identisch sind oder wobei sich das erste und das zweite Brennstoffzellensystem (100, 200) voneinander unterscheiden und die Anordnung (1) des Fahrzeug-Brennstoffzellensystems so ausgelegt ist, dass sie die Unterschiede bei der Durchführung der Sensorplausibilitätsprüfung berücksichtigt.

9. Fahrzeug (400), umfassend die Anordnung (1) des Fahrzeug-Brennstoffzellensystems nach einem der vorhergehenden Ansprüche, wobei das Fahrzeug (400) optional ein Schwerlastfahrzeug wie ein Lastwagen oder ein Bus ist.

10. Verfahren (500) zum Betreiben einer Anordnung (1) eines Fahrzeug-Brennstoffzellensystems, wobei das Verfahren (500) Folgendes umfasst:
- erstes Steuern (510) eines ersten Brennstoffzellensystems (100) mittels einer ersten Steuereinheit (120) und auf Grundlage eines Wertes eines ersten Brennstoffzellensensors (110),
- zweites Steuern (520) eines zweiten Brennstoffzellensystems (200) mittels einer zweiten Steuereinheit (220) und auf der Grundlage eines Wertes eines zweiten Brennstoffzellensensors (210),
- Versorgen (530) mit Kühlmittel, Luft oder Brennstoff des ersten und des zweiten Brennstoffzellensystems (100, 200) über eine gemeinsame Versorgung (50),
- Durchführen (540) einer Plausibilitätsprüfung des ersten Sensors (110) und des zweiten Sensors (210), wobei das Verfahren **dadurch gekennzeichnet, dass** es ferner Folgendes umfasst:
- Betreiben (550) des ersten und zweiten Brennstoffzellensystems (100, 200) unter Verwendung eines Wertes eines Sensors (110, 210), der die Plausibilitätsprüfung bestanden hat, anstelle eines Wertes eines Sensors (110, 210), der die Plausibilitätsprüfung nicht bestanden hat.

11. Verfahren (500) nach Anspruch 10, wobei das Durchführen (540) der Plausibilitätsprüfung auf Werten des ersten Brennstoffzellensensors (110), des zweiten Brennstoffzellensensors (210) und eines Fahrzeugsensors (10) basiert.

12. Verfahren (500) nach Anspruch 11, umfassend,
wenn der erste Brennstoffzellensensor (110) die Plausibilitätsprüfung nicht besteht, Betreiben (550) des ersten und des zweiten Brennstoffzellensystems (100, 200) unter Verwendung eines Wertes des Fahrzeugsensors (10),
wenn der zweite Brennstoffzellensensor (210) die Plausibilitätsprüfung nicht besteht, Betreiben (550) des ersten und des zweiten Brennstoffzellensystems (100, 200) unter Verwendung eines Wertes des Fahrzeugsensors (10), und,
wenn der Fahrzeugsensor (10) die Plausibilitätsprüfung nicht besteht, Betreiben (550) des ersten und des zweiten Brennstoffzellensystems (100, 200) unter Verwendung eines Wertes des ersten Brennstoffzellensensors (110) und/oder des zweiten Brennstoffzellensensors (210).

13. Verfahren (500) nach Anspruch 10, 11 oder 12, wobei das Verfahren computerimplementiert ist.

14. Computerprogrammprodukt, umfassend Programmcode zum Ausführen, bei Ausführung durch eine Prozessorvorrichtung einer Steuerung (60), des computerimplementierten Kurzschlussdiagnoseverfahrens (100) nach Anspruch 13.

15. Nicht-transitorisches, computerlesbares Speichermedium, umfassend Befehle, die, wenn sie von einer Prozessorvorrichtung einer Steuerung (60) ausgeführt werden, die Verarbeitungsschaltung veranlassen, das computerimplementierte Kurzschlussdiagnoseverfahren (100) nach Anspruch 13 durchzuführen.

## Revendications

1. Ensemble de systèmes de pile à combustible de véhicule (1) comprenant
- un premier système de pile à combustible (100) comprenant un premier capteur (110) et une première unité de commande (120) adaptée pour commander le premier système de pile à combustible (100) sur la base d'une valeur du premier capteur (110),
- un deuxième système de pile à combustible (200) comprenant un deuxième capteur (210) et une deuxième unité de commande (220) adaptée pour commander le deuxième système de pile à combustible (200) sur la base d'une valeur du deuxième capteur (210), et
- une alimentation commune (50) en liquide de refroidissement, en air ou en carburant des premier et deuxième systèmes de pile à combustible (100, 200),
dans lequel le système de pile à combustible de véhicule (1) est configuré pour réaliser un contrôle de plausibilité de capteur du premier capteur (110) et du deuxième capteur (210), **caractérisé en ce que** le système de pile à combustible du véhicule (1) est en outre configuré pour utiliser une valeur d'un capteur (110, 210) qui a passé le contrôle de plausibilité au lieu d'une valeur d'un capteur (110, 210) qui n'a pas passé le contrôle de plausibilité, de sorte que l'exploitation des premier et deuxième systèmes de pile à combustible (100, 200) est autorisée dans le cas où un capteur (110, 210) ne passe pas le contrôle de plausibilité.

2. Ensemble de systèmes de pile à combustible de véhicule (1) selon la revendication 1, dans lequel les premier et deuxième systèmes de pile à combustible (100, 200) comprennent ou sont connectés à un circuit de refroidissement commun (60) et comprennent donc une alimentation commune (50) en liquide de refroidissement, et dans lequel les premier et deuxième capteurs (110, 210) sont des capteurs de température et/ou des capteurs de pression.

3. Ensemble de systèmes de pile à combustible de véhicule (1) selon la revendication 1 ou 2, comprenant
soit
- un capteur de véhicule (10) associé à l'alimentation commune (50), et
- une unité de commande de véhicule (20) en communication avec la première unité de commande (120), la deuxième unité de commande (220) et le capteur de véhicule (10),
dans lequel l'unité de commande de véhicule (20) est configurée pour, sur la base des valeurs du premier capteur (110), du deuxième capteur (210) et du capteur de véhicule (10), réaliser un contrôle de plausibilité de capteur du premier capteur (110), du deuxième capteur (210) et du capteur de véhicule (10),
soit
- le premier système de pile à combustible (100) comprenant éventuellement un troisième capteur (112), et
- le deuxième système de pile à combustible (200) comprenant éventuellement un quatrième capteur (212), dans lequel la première unité de commande (120) et la deuxième unité de commande (220) sont en communication l'une avec l'autre, et la première unité de commande (120) est configurée pour, sur la base des valeurs provenant du premier capteur (110), éventuellement du troisième capteur (112) et de la deuxième unité de commande (220), réaliser un contrôle de plausibilité de capteur du premier capteur (110), et la deuxième unité de commande (220) est configurée pour, sur la base des valeurs provenant du deuxième capteur (210), éventuellement du quatrième capteur (212) et de la première unité de commande (120), réaliser un contrôle de plausibilité de capteur du deuxième capteur (210),
soit
comprenant
- un troisième système de pile à combustible (300) comprenant un troisième capteur (310) et une troisième unité de commande (320),
dans lequel l'ensemble de systèmes de pile à combustible de véhicule (1) est configuré pour, sur la base des valeurs du premier capteur (110), du deuxième capteur (210) et du troisième capteur (310), réaliser un contrôle de plausibilité de capteur du premier capteur (110), du deuxième capteur (210) et du troisième capteur (310).

4. Ensemble de systèmes de pile à combustible de véhicule (1) selon une quelconque revendication précédente, comprenant une unité de commande de véhicule (20) en communication avec la première unité de commande (120) du premier système de pile à combustible (100) et avec la deuxième unité de commande (220) du deuxième système de pile à combustible (200), dans lequel l'unité de commande de véhicule (20) est configurée pour, sur la base des valeurs provenant du premier capteur (110) et du deuxième capteur (210), réaliser un contrôle de plausibilité de capteur du premier capteur (110) et du deuxième capteur (210).

5. Ensemble de systèmes de pile à combustible de véhicule (1) selon une quelconque revendication précédente, comprenant ou connecté à un capteur de véhicule (10) associé à l'alimentation commune (50).

6. Ensemble de systèmes de pile à combustible de véhicule (1) selon les revendications 4 et 5, dans lequel l'unité de commande du véhicule (20) est configurée pour, sur la base des valeurs du premier capteur (110), du deuxième capteur (210) et du capteur de véhicule (10), réaliser un contrôle de plausibilité de capteur du premier capteur (110), du deuxième capteur (210) et du capteur de véhicule (10).

7. Ensemble de systèmes de pile à combustible de véhicule (1) selon une quelconque revendication précédente, dans lequel la première unité de commande (120) et la deuxième unité de commande (220) sont en communication l'une avec l'autre, la première unité de commande (120) comprend un troisième capteur (112), la deuxième unité de commande (220) comprend un quatrième capteur (212), et
la première unité de commande (120) est configurée pour, sur la base des valeurs du premier capteur (110), du troisième capteur (112) et de la deuxième unité de commande (220), réaliser un contrôle de plausibilité de capteur du premier capteur (110), et
la deuxième unité de commande (220) est configurée pour, sur la base des valeurs du deuxième capteur (210), du quatrième capteur (212) et de la première unité de commande (120), réaliser un contrôle de plausibilité de capteur du deuxième capteur (210).

8. Ensemble de systèmes de pile à combustible de véhicule (1) selon une quelconque revendication précédente, dans lequel les premier et deuxième systèmes de pile à combustible (100, 200) sont essentiellement identiques, ou dans lequel les premier et deuxième systèmes de pile à combustible (100, 200) sont différents l'un de l'autre et l'ensemble de systèmes de pile à combustible de véhicule (1) est adapté pour prendre en compte les différences lors de la réalisation du contrôle de plausibilité de capteur.

9. Véhicule (400) comprenant l'ensemble de systèmes de pile à combustible de véhicule (1) selon l'une quelconque des revendications précédentes, dans lequel le véhicule (400) est éventuellement un véhicule lourd tel qu'un camion ou un autobus.

10. Procédé (500) de fonctionnement d'un ensemble de systèmes de pile à combustible de véhicule (1), le procédé (500) comprenant :
- la première commande (510) d'un premier système de pile à combustible (100) au moyen d'une première unité de commande (120) et sur la base d'une valeur d'un premier capteur de pile à combustible (110),
- la deuxième commande (520) d'un deuxième système de pile à combustible (200) au moyen d'une deuxième unité de commande (220) et sur la base d'une valeur d'un deuxième capteur de pile à combustible (210),
- la fourniture (530) de liquide de refroidissement, d'air ou de carburant aux premier et deuxième systèmes de pile à combustible (100, 200) au moyen d'une alimentation commune (50),
- la vérification de plausibilité (540) du premier capteur (110) et du deuxième capteur (210), dans lequel le procédé est **caractérisé en ce qu'**il comprend en outre :
- l'exploitation (550) des premier et deuxième systèmes de pile à combustible (100, 200) en utilisant une valeur d'un capteur (110, 210) qui a passé le contrôle de plausibilité au lieu d'une valeur d'un capteur (110, 210) qui n'a pas passé le contrôle de plausibilité.

11. Procédé (500) selon la revendication 10, dans lequel le contrôle de plausibilité (540) est basé sur des valeurs provenant du premier capteur de pile à combustible (110), du deuxième capteur de pile à combustible (210) et d'un capteur de véhicule (10).

12. Procédé (500) selon la revendication 11, comprenant
si le premier capteur de pile à combustible (110) ne passe pas le contrôle de plausibilité, l'exploitation (550) des premier et deuxième systèmes de pile à combustible (100, 200) en utilisant une valeur du capteur de véhicule (10),
si le deuxième capteur de pile à combustible (210) ne passe pas le contrôle de plausibilité, l'exploitation (550) des premier et deuxième systèmes de pile à combustible (100, 200) en utilisant une valeur du capteur de véhicule (10), et
si le capteur de véhicule (10) ne passe pas le contrôle de plausibilité, l'exploitation (550) des premier et deuxième systèmes de pile à combustible (100, 200) en utilisant une valeur du premier capteur de pile à combustible (110) et/ou du deuxième capteur de pile à combustible (210).

13. Procédé (500) selon la revendication 10, 11 ou 12, dans lequel le procédé est mis en œuvre par ordinateur.

14. Produit programme d'ordinateur comprenant un code de programme pour réaliser, lorsqu'il est exécuté par un dispositif de processeur d'un contrôleur (60), le procédé de diagnostic de court-circuit mis en œuvre par ordinateur (100) selon la revendication 13.

15. Support de stockage non transitoire lisible par ordinateur comprenant des instructions qui, lorsqu'elles sont exécutées par un dispositif de processeur d'un contrôleur (60), amènent le circuit de traitement à réaliser le procédé de diagnostic de court-circuit mis en œuvre par ordinateur (100) selon la revendication 13.
